# EUROPEAN PATENT APPLICATION

(11) **EP 1 538 798 A2**
(43) Date of publication of application: **08.06.2005**
(21) Application number: 04106298.5
(22) Date of filing: 03.12.2004
(51) Int. Cl.: H04L 27/20, H04L 27/36

(54) **Wireless commmunication unit, linearised transmitter circuit and method of linearising therein**

(30) Priority: 04.12.2003 GB 0328110
(71) Applicant: MOTOROLA, INC., Schaumburg, IL 60196 (US)
(72) Inventor: Ben-Ayun, Moshe, 67899, Tel Aviv (IL); Grossman, Ovadia, 67899, Tel Aviv (IL); Rozental, Mark, 67899, Tel Aviv (IL)
(74) Representative: McCormack, Derek James

(57) **Abstract**

A wireless communication unit (300) comprises a linearised transmitter (325, 500) having a power amplifier (324), a forward path and a feedback path for feeding back a portion of a signal to be transmitted, wherein the feedback path and forward path form two loops in quadrature. A processor (322) applies one or more training signals to a first quadrature circuit loop and a second quadrature circuit loop and measures a quadrature imbalance between the first and second quadrature circuit loops. In response the processor adjusts at least one parameter setting of a loop adjustment function (442) to balance the quadrature circuit loops. A linearised transmitter and method of training are also described.

The measuring and compensating for any loop imbalance between 'I' and 'Q' paths around a feedback path provides improved accuracy and stability in phase and/or amplitude.

## Description

### Field of the Invention

This invention relates to a radio transmitter in a wireless communication unit. The invention is applicable to, but not limited to, a training mechanism to configure a radio transmitter that employs a linearisation technique in order to provide a stable, linear output.

### Background of the Invention

Wireless communication systems, for example cellular telephony or private mobile radio communication systems, typically provide for radio telecommunication links to be arranged between a plurality of base transceiver stations (BTSs) and a plurality of subscriber units, often termed mobile stations (MSs). The term mobile station generally includes both hand-portable and vehicular mounted radio units. Radio frequency (RF) transmitters are located in both BTSs and MSs in order to facilitate wireless communication between the communication units.

In the field of this invention, it is known that there is continuing pressure on the limited radio spectrum available for radio communication systems, which is focusing attention on the development of spectrally efficient linear modulation schemes. By using spectrally efficient linear modulation schemes, more communication units are able to share the allocated spectrum within a defined geographical coverage area (communication cell). An example of a digital mobile radio system that uses a linear modulation method, such as n/4 digital quaternary phase shift keying (DQPSK), is the TErrestrial Trunked RAdio (TETRA) system, developed by the European Telecommunications Standards Institute (ETSI).

Since the envelopes of these linear modulation schemes fluctuate, intermodulation products can be generated in the non-linear radio frequency (RF) power amplifier(s). Specifically in the digital private mobile radio (PMR) market, restrictions on out-of-band emissions are severe (to the order of -60dBc to -70dBc relative to the power in adjacent frequency channels). Hence, linear modulation schemes used in this scenario require highly linear transmitters.

The actual level of linearity needed to meet particular out-of-band emission limits, is a function of many parameters, of which the most critical parameters are modulation type and bit rate. Quantum processes within a typical radio frequency (RF) amplifying device are non-linear by nature. Only a straight line may approximate the transfer function of the amplifying device when a small portion of the consumed direct current (DC) power is transformed into radio frequency (RF) power, i.e. as in an ideal linear amplifier case. This mode of operation provides a low efficiency of DC to RF power conversion, which is unacceptable for portable units.

The emphasis in portable PMR equipment is to increase battery life. Hence, it is imperative to maximise the operating efficiencies of the amplifiers used. To achieve both linearity and efficiency, so called linearisation techniques are used to improve the linearity performance of the more efficient classes of amplifier, for example class AB, B or C amplifiers. One such linearisation technique, often used in designing linear transmitters, is Cartesian Feedback. This is a 'closed loop' negative feedback technique, which sums the baseband feedback signal in its digital 'I' and 'Q' formats with the corresponding generated 'I' and 'Q' input signals in the forward path. The linearising of the power amplifier output requires the accurate setting and on-going control of the phase and amplitude of a feedback signal.

Details of the operation of such a lineariser are described in the paper "Transmitter Linearisation using Cartesian Feedback for Linear TDMA Modulation" by M Johansson and T Mattsson 1991 IEEE.

The lineariser circuit optimises the performance of the transmitter, for example to comply with linearity or output power specifications of the communication system, or to optimise the operating efficiency of the transmitter power amplifier. Operational parameters of the transmitter are adjusted to optimise the transmitter performance and include as an example, one or more of the following: amplifier bias voltage level, input power level, phase shift of the signal around the feedback path. Such adjustments are performed by say, a microprocessor. Due to the sensitivity of such transmitter circuits, a range of control and adjustment circuits and/or components are needed so that a linear and stable output signal can be achieved under all operating circumstances.

All linearisation techniques require a finite amount of time in which to linearise the performance of a given amplifying device. The 'linearisation' of the amplifying device is often achieved by initially applying a training sequence to the lineariser circuit and the amplifying device in order to determine the levels of phase and gain distortion introduced by the linearisation loop and the amplifying device. Once the phase and gain distortion levels have been determined, they can be compensated for, generally by adjusting feedback components/parameters.

To accommodate for such linearisation requirements, communication systems typically allocate specific training periods for individual users to train their transmitters. The TErrestrial Trunked RAdio (TETRA) standard includes a time frame, termed a Common Linearisation Channel (CLCH) as is described in UK Patent Application No. 9222922.8, to provide a full-training period approximately once every second. The CLCH frame allows a radio to 'train' prior to gaining access to the system. However, a radio having to wait up to one second before training and then accessing the system is undesirable. To minimise the effect of this significant delay in call set-up times, and also provide an additional period for fine tuning a radio's output characteristics, due to changes in temperature, supply voltage or frequency of operation, a reduced training sequence has been inserted at the beginning of each TETRA traffic time slot for the radio allocated that slot to perform a minimal amount of training or fine tuning. This period may be used for phase training.

An example of such a training sequence is described in US Patent No. 5,066,923 of Motorola Inc., which describes a training scheme where the phase of the amplifier is adjusted in an 'open-loop' mode and the gain of the amplifier is adjusted when the loop is closed.

During phase training, the Cartesian feedback loop is configured to be 'open loop', i.e. a switch is used to prevent the fed-back signal from being combined with the signal routed through the transmitter circuit. In this regard, in a phase training mode of operation, a positive signal is applied to the I-channel input. The phase shift around the loop is measured and, in response to the measured I-channel phase shift, the phase around the loop on both the 'I'-channel and the 'Q'-channel is adjusted by a phase shifter.

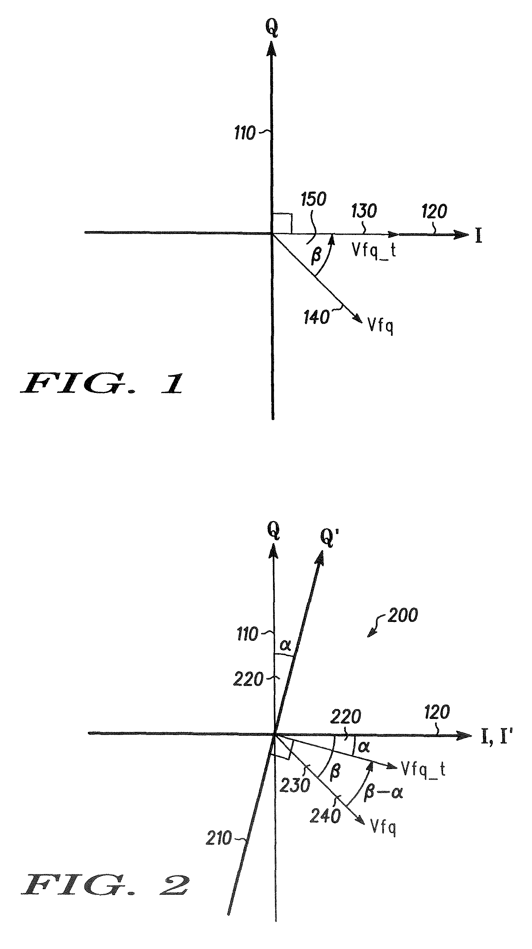

FIG. 1 illustrates a phase diagram 100 with a perfect I/Q quadrature balance, i.e. a 90-degree phase difference between the 'I'-channel 120 and the 'Q'-channel 110. One method for controlling/setting the phase and amplitude levels around the loop is described here. The Cartesian loop is opened and a positive baseband signal applied to the input of the 'I'-channel. Phase training control circuitry monitors the signal before switch on the 'Q'-channel - indicated as Vfq 140. A successive approximation register (SAR) phase training algorithm controls the phase shifter and minimises the Vfq voltage. At the end of the SAR algorithm, phase training corrects the loop phase from Vfq 140 to Vfq_t 130 by an angle β 150. A voltage value measured on the 'Q'-channel prior to the switch is then reduced to a level close to zero. The same process is repeated for a negative baseband signal input to the 'I'-channel. The calculated results from both the positive and negative training applied to the 'I'-channel are averaged and used to adjust the phase around both the 'I'-channel loop and the 'Q'-channel loop.

The inventors of the present invention have recognised and appreciated that, in practice, the perfect I-Q 90-degree relationship is rarely achieved. This imbalance results from the various component tolerances within the respective 'I' and 'Q' loops. An unbalanced phase relationship 200 is illustrated in FIG. 2. Here, Q' is the actual loop's quadrature axis 210. The Q' axis 210 deviates from the ideal Q axis 110 by α degrees 220. Again, Vfq is minimized using Q' axis 210 as quadrature. In a similar manner, the gain applied to and/or provided by the various components in the linearization loop can cause a quadrature amplitude imbalance between the 'I'-channel and the 'Q'-channel.

From FIG. 2, we can see that instead of correcting the loop phase by β degrees 230, the phase training process has corrected the loop phase by β-α degrees 240. This means that phase training provides a result that is inaccurate by α degrees 220.

The inventors of the present invention have identified that any quadrature imbalance in the generation of linearised signals during the training sequence of a Cartesian loop transmitter may cause significant phase training errors. Accurate phase training is a critical stage in the linearisation of such transmitter circuits, as the phase accuracy has a substantial effect on loop stability and wideband noise.

Thus, there currently exists a need to provide an improved transmitter circuit, and in particular a mechanism for improving amplitude and phase training accuracy, wherein the abovementioned disadvantages may be alleviated.

### Statement of Invention

In accordance with a first aspect of the present invention, there is provided a wireless communication unit. The wireless communication unit comprises a linearised transmitter having a power amplifier for transmitting a linearised radio signal; a forward path for routing a signal to be transmitted; and a feedback path, operably coupled to the power amplifier and the forward path for feeding back a portion of signal to be transmitted. The feedback path and forward path form two loops in quadrature. One or more loop adjustment functions adjust a loop parameter of one or more signals applied to the linearised transmitter. A processor applies one or more training signals to a first quadrature circuit loop and a second quadrature circuit loop and measures a quadrature imbalance between the first and second quadrature circuit loops. In response, the processor adjusts at least one parameter setting of the loop adjustment function to balance the quadrature circuit loops.

In accordance with a second aspect of the present invention, a linearised transmitter integrated circuit is provided, as defined in Claim 9.

In accordance with a third aspect of the present invention, a method of linearising a transmitter is provided. The transmitter comprises a forward path and a feedback path comprising a loop adjustment function, wherein the forward path and feedback path form two loops in quadrature. The method comprises the steps of applying a training signal to be routed through the two quadrature loops of the linearised transmitter and measuring a quadrature imbalance between the two quadrature loops based on the training signal. At least one parameter setting of a loop adjustment function is adjusted based on the measured quadrature imbalance, to balance the quadrature loops.

Preferably, the loop adjustment function is a phase shifter for adjusting a phase shift in the first and/or second quadrature loops or an amplitude/attenuator function for adjusting a gain to be applied to a signal in the first and/or second quadrature loops.

In this manner, by measuring and compensating for any loop imbalance between digital 'I' and 'Q' paths around a feedback loop, improved accuracy and stability in phase and/or amplitude around the loops can be obtained.

In accordance with a fourth aspect of the present invention, a storage medium is provided, as defined in Claim 13.

Further aspects of the invention are provided in the dependent claims.

### Brief Description of the Drawings

FIG. 1 shows a phase diagram of an ideal I-Q relationship in a feedback loop of a linear transmitter arrangement; and
FIG. 2 shows a phase diagram of an unbalanced I-Q relationship in a feedback loop of a linear transmitter arrangement.

Exemplary embodiments of the present invention will now be described, with reference to the accompanying drawings, in which:
FIG. 3 illustrates a block diagram of a wireless communication unit adapted to support the various inventive concepts of a preferred embodiment of the present invention;
FIG. 4 illustrates a phase diagram showing the adjustments to be made to balance an I-Q relationship of a linearised transmitter adapted in accordance with the preferred embodiment of the present invention;
FIG. 5 illustrates a block diagram of a linearised transmitter topology adapted in accordance with the preferred embodiment of the present invention; and
FIG. 6 illustrates a flowchart of a linearisation training process in accordance with the preferred embodiment of the present invention.

### Description of Preferred Embodiments

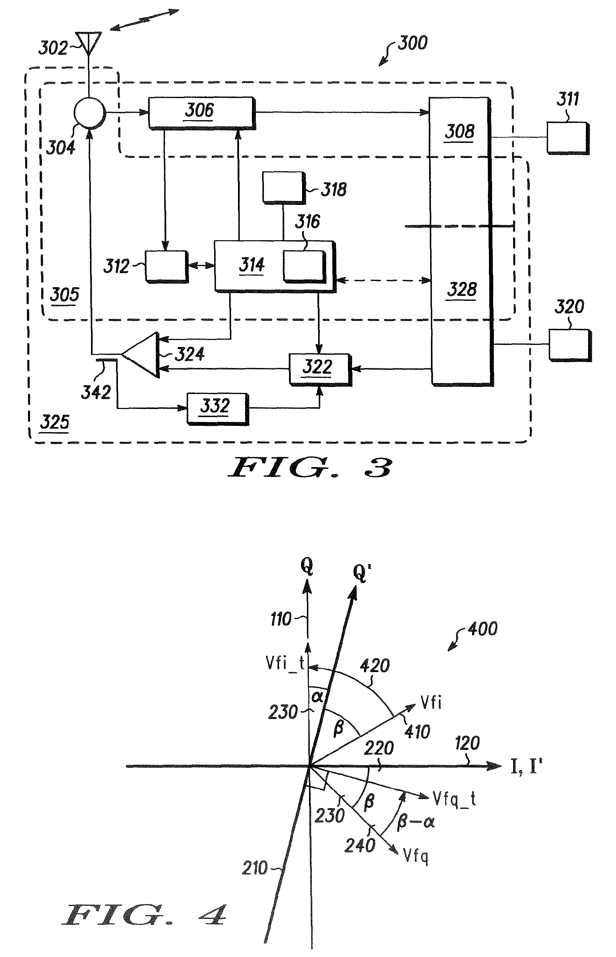

Referring now to FIG. 3, a block diagram of a wireless communication unit 300 adapted to support the inventive concepts of the preferred embodiments of the present invention, is illustrated. For the sake of clarity, the wireless communication unit 300 is shown as divided into two distinct portions - a receiver chain 305 and a transmitter chain 325.

The wireless communication unit 300 contains an antenna 302. The antenna 302 is preferably coupled to an antenna switch 304 that provides signal control of radio frequency (RF) signals in the wireless communication unit 300, as well as isolation between the receiver chain 305 and transmitter chain 325. Clearly, the antenna switch 304 could be replaced with a duplex filter, for frequency duplex communication units as known to those skilled in the art.

For completeness, the receiver 305 of the wireless communication unit 300 will be briefly described. The receiver 305 includes a receiver front-end circuitry 306 (effectively providing reception, filtering and intermediate or base-band frequency conversion). The front-end circuit 306 is serially coupled to a signal processing function (generally realised by at least one digital signal processor (DSP)) 308. A controller 314 is operably coupled to the front-end circuitry 306 so that the receiver can calculate receive bit-error-rate (BER) or frame-error-rate (FER) or similar link-quality measurement data from recovered information via a received signal strength indication (RSSI) 312 function. The RSSI 312 function is operably coupled to the front-end circuit 306. A memory device 316 stores a wide array of data, such as decoding/encoding functions and the like, as well as amplitude and phase settings to ensure a linear and stable output. A timer 318 is operably coupled to the controller 314 to control the timing of operations, namely the transmission or reception of time-dependent signals.

As regards the transmit chain 325, this essentially includes a processor 328, lineariser circuitry (including transmitter/ modulation circuitry) 322 and an up-converter/power amplifier 324. The processor 328, lineariser circuitry 322 and the up-converter/power amplifier 324 are operationally responsive to the controller 314, with an output from the power amplifier 324 coupled to the antenna switch 304. A feedback circuit includes a down-converter 332, which forms together with the lineariser circuitry 322 power amplifier 324 and directional coupler 342 a real-time Cartesian feedback loop to ensure a linear, stable transmitter output.

Prior to transmitting real data, the linearised transmitter of the preferred embodiment of the present invention employs a training algorithm, to determine appropriate gain and phase adjustment parameters to ensure a stable, linear output. Notably, the preferred embodiment of the present invention proposes a mechanism that improves an accuracy of the phase and/or amplitude training, for example utilising the training algorithm described in US Patent No. 5,066,923 of Motorola Inc., which is incorporated herein by reference. The inventive concepts propose a mechanism to calculate a quadrature phase and/or amplitude imbalance within the loop and thereafter compensate for the imbalance.

Although the preferred embodiment of the present invention is described with reference to phase and/or amplitude training, it is envisaged that the inventive concepts are equally applicable to any other training signals that can be routed around the respective quadrature loops to identify imbalances there between.

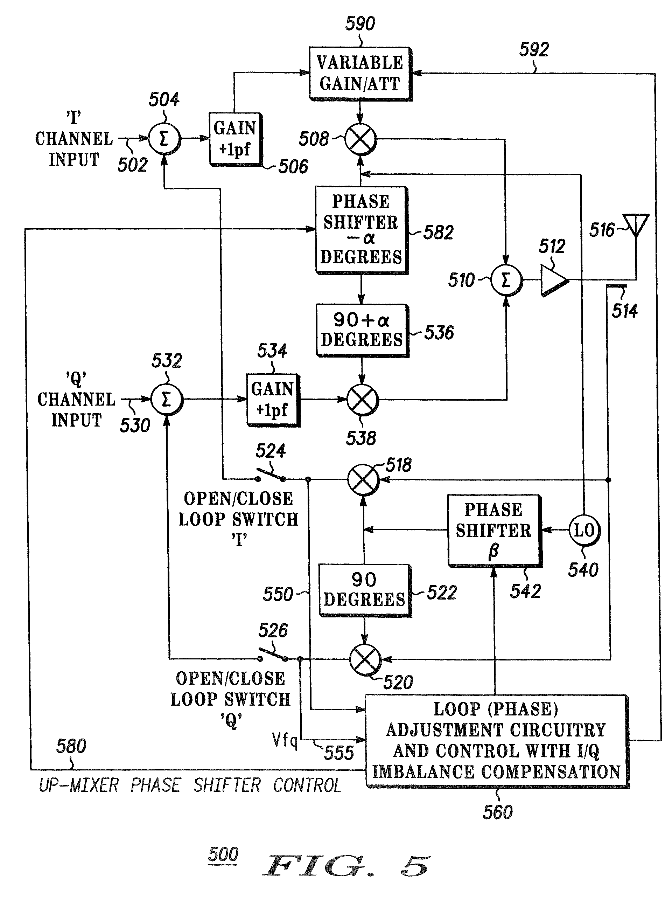

Referring now to FIG. 4, a phase diagram 400 of an unbalanced I-Q relationship is illustrated, whereby the phase has been modified in the feedback loop of the linear transmitter arrangement according to the preferred embodiment of the present invention. From FIG. 4, it can be seen that when phase training is being performed on the 'I' channel, the phase loop correction is β-α 240.

The 'Q' channel loop phase is set to the phase setting used before performing the I-channel phase training. Now, when phase training is being performed on the Q' channel, the correction is β+α 420.

From the above calculations it is possible to calculate the quadrature phase imbalance α 230 within the loop.

FIG. 5 shows a more detailed Cartesian loop configuration 500, adapted to support the preferred embodiment of the present invention. The configuration is described in the context of a phase training process, but clearly the same configuration is used when transmitting real data.

A phase training signal, for example a sine wave, is input to the 'I'-channel 502. The phase training signal is not combined with any other signal in summing junction 504, as the circuit has been arranged for open-loop operation by controlling switch 524 (with a similar control for 'Q'-channel with switch 526). The input signal is then input to a gain and low-pass filter block 506 where it is amplified and filtered. The amplified and filtered signal is then passed through a variable gain/attenuator function 590, which is primarily used in a subsequent amplitude training operation. The amplified input signal is then up-converted by mixing it with a signal from local oscillator 540 in mixer 508. The up-converted signal is then routed to the RF amplifier chain 512, where a portion of the amplified RF signal is fed back via directional coupler 514.

The fed back signal is routed to down-conversion mixer 518, where it is mixed with a phase-shifted 542 version of a signal from the local oscillator 540. The amount of phase shift is controlled by a phase calculation and adjustment function 560.

In accordance with the preferred embodiment of the present invention, a second phase training sequence is now applied to the 'Q'-channel input 530. The phase training signal, preferably the same sine wave, is input to the 'Q'-channel. The phase training signal is not combined with any other signal in summing junction 532, as the circuit has been arranged for open-loop operation by controlling switch 526. The 'Q'-channel input signal is then input to a gain and low-pass filter block 534 where it is amplified and filtered. The amplified input signal is then up-converted by mixing it with a '90+α' degree (536) phase-shifted representation of a signal from the local oscillator 540 in mixer 538. The up-converted signal is then routed to the RF amplifier chain 512, where a portion of the amplified RF signal is fed back via directional coupler 514.

The fed back signal is routed to down-conversion mixer 520, where it is mixed with a phase-shifted 542 version of the local oscillator signal. The phase-shifted version of the local oscillator signal has been further phase shifted by ninety-degrees 522 to account for the ideal I-Q quadrature nature of the circuit. The amount of phase shift is again controlled by the phase calculation and loop adjustment function 560.

In this manner, the phase shift of both the 'I'-channel loop and the 'Q'-channel loop through all of the components up to the switch point is measured. Once the respective phase-shifts have been calculated, they are compensated for by appropriate adjustment of the phase-shifter, under control of the phase calculation and loop adjustment function 560.

Notably, in accordance with the preferred embodiment of the present invention, the lineariser circuit incorporates circuitry to measure and adjust component operations to compensate for amplitude and/or phase imbalances in the lineariser loop. With regard to quadrature phase compensation, the phase adjustment circuitry and control function 560 has been adapted to calculate a quadrature phase imbalance between the 'I'-channel and 'Q'-channel, from the monitored loop signals on lines 550 and 555. A control signal 580 is then applied to a phase shifter 582 introduced into the up-mixer quadrature generator circuitry. As the quadrature phase imbalance α has been calculated by the phase adjustment circuitry and control function 560 it can be compensated for by appropriate adjustment of the phase shifter 582, for example by programming up-mixer phase shifter 582 to apply a phase shift of -α to the local oscillator signal applied through it. Thus, by applying a local oscillator signal to the phase shifter exerting a phase shift of '-α', and then applying this signal to the '90+α' degree 536 a quadrature (I-Q) phase imbalance ((90+α) + (-α) = 90 degrees) is being compensated for.

Although the preferred embodiment of the present invention has described the quadrature (I-Q) phase imbalance α compensation circuit applied in the up-mixer path, it is within the contemplation of the invention that the compensation circuit may equally be applied to the down-mixer path, as α is actually the sum of the up-mixer and down-mixer I-Q generator's imbalance.

Once the phase training process has been performed, resulting in a quadrature balance in phase between the 'I'-channel and the 'Q'-channel, the preferred embodiment proposes a mechanism to compensate for quadrature amplitude imbalance between the 'I'-channel and the 'Q'-channel within the loop. Preferably, amplitude imbalance compensation is performed after phase compensation to ensure that there is no (or at least minimal) I-Q leakage.

With regard to amplitude imbalance compensation, it is first necessary to calculate the amount of amplitude imbalance. First, the Cartesian loop is opened by opening/closing loop switches 524, 526 for the 'I'-channel and 'Q'-channel respectively. Equal DC voltage is applied to the 'I'-channel input 502 and 'Q'-channel input 530. As before with the phase imbalance calculation, the respective voltages Vfi and Vfq are measured before the open/close loop switches 524 and 526 on lines 550 and 555. These measurements are then compared, for example by using a simple comparator (not shown) in the phase adjustment circuitry and control function 560. Once the quadrature amplitude imbalance has been calculated, the phase adjustment circuitry and control function 560 applies a control signal 592 to the variable amplifier/attenuator element (or circuit) 590 to adjust the gain of the 'I'-channel input signal until the voltages Vfi and Vfq are equal (Vfi=Vfq). Thus, in this manner, any quadrature gain imbalance between the 'I'-channel and 'Q'-channel is compensated for.

It is envisaged that the aforementioned training mechanism is preferably implemented using a signal processor function. More generally, the inventive concepts may be implemented in a wireless communication unit in any suitable manner for example by re-programming or adapting a processor in the wireless communication unit. For example, a new processor may be added to a conventional wireless communication unit, or alternatively existing parts of a conventional wireless communication unit may be adapted, for example by reprogramming one or more processors therein. As such the required adaptation may be implemented in the form of processor-implementable instructions stored on a storage medium, such as a floppy disk, hard disk, programmable read-only memory (PROM), random access memory (RAM) or any combination of these or other storage media.

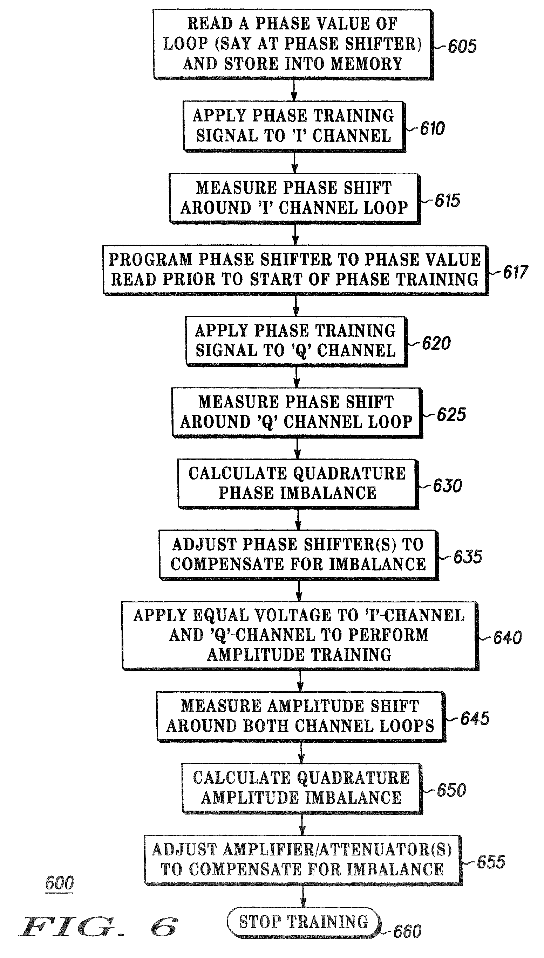

In summary, the improved phase and amplitude training process is illustrated in the flowchart 600 of FIG. 6. The linearisation training process preferably comprises a phase training process followed by an amplitude training process. First a value of phase (for example a value of phase shifter 542 of FIG. 5) is read prior to phase training and stored into memory (as 'X' deg) in step 605. A training signal, for example a phase training signal, is input to a first quadrature loop, for example the 'I' channel loop, in step 610. The phase shift exerted upon the phase training signal around the 'I' channel loop is then measured in step 615.

This phase shift (say, of phase shifter 542 of FIG. 5) is 'β-α'. This value is recorded. The phase shifter's value is then programmed to the original value (i.e. the value prior to phase training, namely 'X' degrees), as shown in step 617. A training signal, and preferably the same phase training signal, is then input to a second quadrature loop, for example the 'Q' channel loop, in step 620. The phase shift exerted upon the phase training signal around the 'Q' channel loop is then measured in step 625. This phase shift (say of phase shifter 542 of FIG. 5) is 'β+α'. This value is recorded.

Using the respective phase shifts that were measured in steps 615 and 625, a value for the quadrature phase imbalance α, is then calculated, in step 630 by solving two algebraic equations with two unknowns. Any quadrature phase imbalance is then compensated for by appropriate adjustment of a phase shifter in either or both paths, as shown in step 635.

The next step preferably compensates for any quadrature amplitude imbalance within the loop. The Cartesian loop is again opened by opening/closing appropriate loop switches for the 'I'-channel and 'Q'-channel. Equal DC voltages are applied to both the 'I'-channel and 'Q'-channel inputs, as in step 640. The amplitude shift around the respective 'I'-channel and 'Q'-channel loops is then measured, as shown in step 645. Any difference between the respective amplitude shifts, i.e. a quadrature amplitude imbalance, is then calculated, in step 650. Any quadrature amplitude imbalance is then compensated for by appropriate adjustment of an amplification or attenuation element in either or both paths, as shown in step 655. The phase and amplitude training process is then complete as shown in step 660.

It is within the contemplation of the invention that the phase shifter is adjusted after performing both the I-channel phase training and the Q-channel phase training. However, it is envisaged that in some circumstances the phase-shifter may be adjusted after each individual phase calculation has been made.

It is envisaged that, for other linear transmitter topologies or linearisation techniques, a training sequence, for example phase training, on the 'I' channel and the 'Q' channel may be performed simultaneously, rather than successively. It is also envisaged that the use of two training sequences: one for the I-channel and one for the Q-channel, may comprise any combination or order of phase training and/or amplitude training processes.

The phase and amplitude compensation mechanisms are preferably performed in the forward (up-mixer) path to avoid changing the I/Q imbalance of the feedback path that is the loop correction reference.

In summary, a new phase and amplitude training method for elimination of errors in a Cartesian feedback loop linear transmitter has been described. The aforementioned inventive concepts provide a mechanism for compensating quadrature generator imbalances within the transmitter. Advantageously, I-Q imbalance of both forward and feedback quadrature generator circuits are compensated for, both of which influence the phase and amplitude adjustment/compensation calculations. Furthermore, as imbalances in the forward and backward quadrature generator circuits are compensated for, it is possible to use less expensive components with a reduced tolerance and performance.

It is envisaged that integrated circuit manufacturers may utilise the inventive concepts hereinbefore described. For example, it is envisaged that a radio frequency linearised transmitter integrated circuit (IC) containing the aforementioned transmitter circuit arrangement and method of training could be manufactured to be incorporated into a wireless communication unit.

Advantageously, the inventive concepts of the present invention provide a significant benefit to the manufacturers of linearised transmitter circuits, by compensating for quadrature imbalance due to an improvement in the accuracy of a training process. For example, it is also within the contemplation of the invention that alternative linearisation techniques can benefit from the inventive concepts described herein. As an alternative to using Cartesian feedback, a pre-distortion form of lineariser may be adapted to implement the preferred or alternative embodiments of the present invention. Y. Nagata described an example of a suitable pre-distortion transmitter configuration in the 1989 IEEE paper titled "Linear Amplification Technique for Digital Mobile Communications".

Nevertheless, it is within the contemplation of the invention that the transmitter configuration of the preferred embodiment of the present invention may be applied to any wireless transmitter circuit.

Furthermore, it is within the contemplation of the invention that the wireless communication unit employing the linearised transmitter may be any wireless communication device, such as a portable or mobile PMR radio, a mobile phone, a personal digital assistant, a wireless laptop computer, etc. It is also envisaged that the inventive concepts described herein are not limited to use in subscriber equipment, but may also be utilised in other communication units such as base station equipment.

It will be understood that the wireless communication unit, linearised transmitter circuits and methods of training, as described above, tend to provide at least one or more of the following advantages:
(i) The improved amplitude and/or phase training mechanism results in a more stable output of the linearised transmitter circuit;
(ii) The improved phase and/or amplitude training result is/are more accurate as it compensates for any quadrature imbalance between the 'I'-channel and 'Q'-channel. Hence, reduced tolerance components can be used in the loop I/Q generators; and
(iii) The improved phase and/or amplitude training results in a better wideband noise performance.

Whilst specific, and preferred, implementations of the present invention are described above, it is clear that one skilled in the art could readily apply further variations and modifications of such inventive concepts.

Thus, a wireless communication unit with a linearised transmitter topology and improved training mechanism have been described that substantially addresses the problems associated with known linearised transmitters.

## Claims

1. A wireless communication unit (300) comprising a linearised transmitter (325, 500) having:
a power amplifier (324) for transmitting a linearised radio signal;
a first forward path for routing an in-phase signal component to the power amplifier;
a second forward path for routing a quadrature phase signal component to the power amplifier
a first feedback path, operably coupled from the power amplifier (324) to the first forward path for feeding back a portion of a signal output from the power amplifier, the first forward path and the first feedback path forming an in-phase circuit loop;
a second feedback path, operably coupled from the power amplifier (324) to the second forward path for feeding back a portion of a signal output from the power amplifier, the second forward path and the second feedback path forming a quadrature phase circuit loop;
one or more loop adjustment functions (542, 590), to adjust one or more loop parameters of one or more signals applied to the linearised transmitter;
a processor (322) operable to measure an imbalance between the in-phase and quadrature phase circuit loops and, in response, to adjust at least one parameter setting of the loop adjustment function (542,582, 590) wherein the processor is operable to apply training signals to the transmitter including applying a first training signal to the first forward path and applying a second training signal to the second forward path.

2. A wireless communication unit (300) according to Claim 1, wherein the training signals comprise phase training signals and/or an amplitude training signals.

3. A wireless communication unit (300) according to any one preceding Claim, wherein the at least one loop adjustment function (542) is located to adjust a loop parameter in the feedback paths of the respective loops.

4. A wireless communication unit (300) according to any one preceding claim wherein the one or more loop adjustment functions comprise one or more of:
one or more phase shifters (582,542) for adjusting phase of a signal in the first and/or second quadrature circuit loops; or
one or more amplitude or attenuator circuits (590) for adjusting gain applied to a signal in the first and/or second quadrature circuit loops.

5. A wireless communication unit (300) according to any one preceding claim wherein the processor is operable to apply a phase training signal to a first one of the forward paths and to measure a phase value for the circuit loop including that forward path and then to apply a phase training signal to the other one of the forward paths and to measure a phase value for the circuit loop including that forward path then to calculate from the two measurements a loop phase imbalance.

6. A wireless communication unit (300) according to any one preceding Claim, wherein the processor (322) is operable to apply training signals to the forward paths of the linearised transmitter for phase training prior to applying a training signal to the forward paths of the linearised transmitter for amplitude training.

7. A wireless communication unit (300) according to any one preceding Claim, wherein by the linearised transmitter comprises a Cartesian feedback linearised transmitter such that the loop adjustment is applied to a real-time feedback path.

8. A wireless communication unit (300) according to any one preceding Claim, wherein the wireless communication unit is capable of operation in a communication system operable in accordance with TETRA standard procedures.

9. A wireless communication unit (300) according to any one preceding Claim, wherein the wireless communication unit comprises a subscriber unit or a base transceiver station.

10. A linearised transmitter (320) including:
a power amplifier (324) for transmitting a linearised radio signal;
a first forward path for routing an in-phase signal component to the power amplifier;
a second forward path for routing a quadrature phase signal component to the power amplifier
a first feedback path, operably coupled from the power amplifier (324) to the first forward path for feeding back a portion of a signal output from the power amplifier, the first forward path and the first feedback path forming an in-phase circuit loop;
a second feedback path, operably coupled from the power amplifier (324) to the second forward path for feeding back a portion of a signal output from the power amplifier, the second forward path and the second feedback path forming a quadrature phase circuit loop;
one or more loop adjustment functions (542, 590), to adjust a loop parameter of one or more signals applied to the linearised transmitter;
a processor (322) operable to measure an imbalance between the in-phase and quadrature phase circuit loops and, in response, to adjust at least one parameter setting of the loop adjustment function (542,582, 590) wherein the processor is operable to apply training signals to the transmitter including applying a first training signal to the first forward path and applying a second training signal to the second forward path.

11. A method of linearising a transmitter (600) having a power amplifier (324) for transmitting a linearised radio signal; including routing an in-phase signal component to a power amplifier via a first forward path; routing a quadrature phase signal component to the power amplifier via a second forward path; feeding back a portion of a signal output from the power amplifier to the first forward path via a first feedback path forming an in-phase circuit loop with the first forward path, feeding back a portion of a signal output from the power amplifier to the second forward path via a second feedback path forming a quadrature phase circuit loop with the second forward path;
applying training signals to the transmitter including applying a first training signal to the first forward path and applying a second training signal to the second forward path.
measuring a quadrature imbalance (615, 625, 630, 645, 650) between the in-phase and quadrature loops based on the training signals; and
adjusting (635, 655) at least one parameter setting of a loop adjustment function based on the measured quadrature imbalance to balance the in-phase and quadrature loops.

12. A method according to Claim 10 or Claim 11, wherein the step of adjusting comprises adjusting one or more phase shifters for adjusting a phase in the first and/or second quadrature loops; or adjusting one or more amplitude or attenuator circuits for adjusting a gain applied to a signal of the first and/or second quadrature loops.

13. A method according to any one of claims 10 to 12 including applying a phase training signal to a first one of the forward paths, measuring a phase value for the circuit loop including that forward path, applying a phase training signal to the other one of the forward paths, measuring a phase value for the circuit loop including that forward path and then calculating from the two measurements a loop phase imbalance.

14. A method according to any one of claims 10 to 13, including applying training signals to the forward paths of the linearised transmitter for phase training prior to applying a training signal to the forward paths of the linearised transmitter for amplitude training.
